# EUROPEAN PATENT APPLICATION

(11) **EP 4 213 215 A1**
(43) Date of publication of application: **19.07.2023**
(21) Application number: 22151148.8
(22) Date of filing: 12.01.2022
(51) Int. Cl.: H01L 29/06, H01L 29/32, H01L 29/778, H01L 29/20, H01L 29/417, H01L 29/423

(54) **MULTI-FINGER HIGH-ELECTRON MOBILITY TRANSISTOR**

(71) Applicant: Nexperia B.V., 6534 AB Nijmegen (NL)
(72) Inventor: Gajda, Mark, Stockport, SK75BJ (GB); Wynne, Barry, Stockport, SK75BJ (GB)
(74) Representative: Pjanovic, Ilija

(57) **Abstract**

Aspects of the present disclosure relate to a multi-finger high-electron mobility transistor, to a method of manufacturing such a transistor, and to an electronic device comprising such a transistor.

According to an aspect of the present disclosure, an etching step for reducing donor layer (7) thickness and/or performing an ion implantation is used for locally reducing the 2DEG concentration.

## Description

### FIELD

Aspects of the present disclosure relate to a multi-finger high-electron mobility transistor. Aspects of the present disclosure further relate to a method of manufacturing such a transistor and to an electronic device comprising such a transistor.

### BACKGROUND

High-electron mobility transistors, HEMTs, are generally known in the art. These transistors comprise a semiconductor body. The semiconductor body comprises a semiconductor substrate on which a channel layer is formed configured to hold a two-dimensional electron gas, 2DEG, and a donor layer configured to supply electrons for the purpose of forming the 2DEG. For example, a GaN-based HEMT comprises a substrate, such as silicon, silicon carbide, or sapphire, on which a GaN buffer layer is epitaxially grown. On the GaN buffer layer, an AlGaN layer is grown thereby forming a heterojunction. More in particular, a quantum well is formed in the GaN buffer layer near the heterojunction in which electrons accumulate for forming the 2DEG. These electrons originate from the AlGaN layer which may or may not be doped. The upper region of the GaN buffer layer can be referred to as a channel layer and the AlGaN layer can be referred to as the donor layer or barrier layer. Instead of the channel layer corresponding to the upper region of the GaN buffer layer, a separate layer can be epitaxially grown on the GaN buffer layer.

HEMTs can be realized in other semiconductor technologies as well. In each technology, a channel layer and a donor layer can be identified. For example, in GaAs-based HEMTs, the channel layer may correspond to a GaAs layer and the donor layer to an AlGaAs layer.

A HEMT also comprises a drain, source, and gate contact. These contacts are formed using respective contact layers. In some embodiments, the gate contact is formed using a gate contact layer arranged directly on the semiconductor body. In this case the gate contact is a Schottky contact. In other embodiments, an insulating layer is arranged in between the gate contact layer and the underlying semiconductor body. Such arrangement is generally referred to as a metal-insulator-semiconductor, MIS, HEMT or insulated-gate HEMT. Hereinafter, when the wording HEMT is used, it shall refer to both gate configurations unless otherwise stated.

The drain and source contacts are formed using a drain contact layer and source contact layer, respectively, which are arranged directly on the semiconductor body. The source and drain contacts are Ohmic contacts.

For lowering the Ohmic contact resistance, a GaN cap layer may be included in the donor layer. This cap layer may optionally be doped for lowering the contact resistance. Furthermore, this cap layer may or may not have been etched away underneath the gate contact layer.

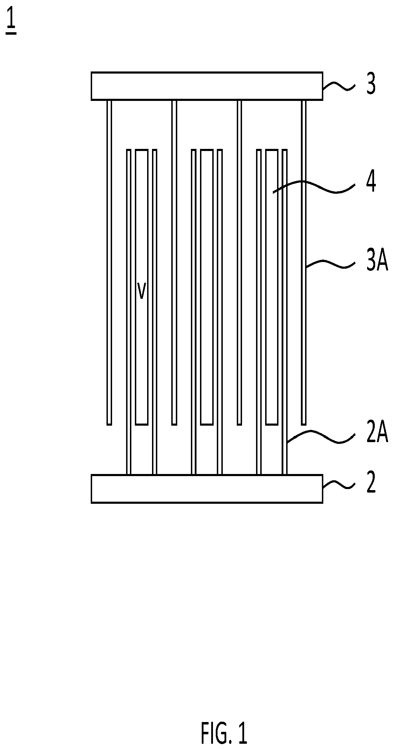

HEMTs that are configured to handle large currents and/or operate at high frequencies may have a multi-finger layout. An example of such a layout is shown in figure 1. As shown, HEMT 1 comprises a gate bar 2 from which a plurality of gate fingers 2A extend. On an opposite side, a drain bar 3 is arranged from which a plurality of drain fingers 3A extend. Source regions or fingers 4 are formed that are interconnected using dielectric cross-overs or airbridges.

It should be noted that within the context of the present disclosure, a gate finger should be interpreted as an elongated conductive structure, typically comprising a plurality of metal layers, and that includes the gate contact layer. Similarly, within the context of the present disclosure, a drain or source finger should be interpreted as an elongated conductive structure, typically comprising a plurality of metal layers, and that includes the drain contact layer or source contact layer, respectively. It is further noted that instead of metal layers other conductive layers, such as polysilicon layers, could equally be used.

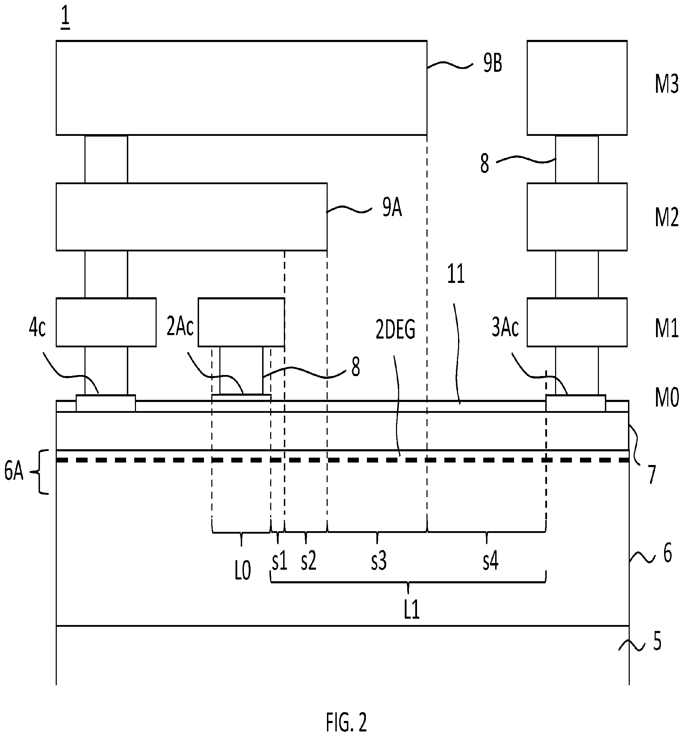

Figure 2 illustrates a schematic cross-sectional view of HEMT 1, more in particular an insulated-gate HEMT, taken along a line perpendicular to gate fingers 2A. As shown, HEMT 1 comprises a substrate 5 on which a buffer layer 6 has been epitaxially grown. On this buffer layer, a donor layer 7 has been grown. As donor layer 7 and buffer layer 6 are made of different materials, a heterojunction is formed. Near this junction, a quantum well is formed in which the two-dimensional electron gas, 2DEG, is situated. The region in buffer layer 6 in which the 2DEG resides, is referred to as channel layer 6A.

The top view shown in figure 1 illustrates gate fingers 2A, drain fingers 3A, and source fingers 4. As shown in figure 2, each of these fingers comprises several metal layers. For example, gate finger 2A comprises a gate contact layer 2Ac that is arranged on insulating layer 11. Similarly, drain finger 3A comprises a drain contact layer 3Ac, and source finger 4 comprises a source contact layer 4c. Source contact layer 4c, drain contact layer 3Ac, and gate contact layer 2Ac, are realized using one or more relatively thin metal layer(s). In figure 2, these metal layers are jointly denoted as metal layer M0 although the metal(s) used for realizing the drain and source contacts is/are generally different from the metal(s) used for realizing the gate contact.

To reduce the Ohmic resistance associated with fingers 2A, 3A, 4, thicker metal layers are used. For example, gate contact layer 2Ac is connected to metal layer M1 using a via 8 that extends through a dielectric layer (not shown) that is arranged on donor layer 7.

Source contact layer 4c is connected to metal layers M1, M2, M3. Here, the structures in metal layers M2 and M3 form fieldplates 9A, 9B that improve the breakdown behavior of HEMT 1. As illustrated, the gate finger structure in metal layer M1 extends a distance s1 beyond the edge of gate contact layer 2Ac. Fieldplate 9A extends a distance s2 beyond the edge of the gate finger structure in metal layer M1, and fieldplate 9B extends a distance s3 beyond the edge of fieldplate 9A.

The region in channel layer 6A directly arranged underneath gate contact layer 2Ac is hereinafter referred to as the first region, and is also known as the channel region. This region has a length L0 in figure 2. The region in channel layer 6A in between the drain contact layer 3Ac and the first region is referred to as the second region, and is also known as the drift region. This latter region has a length L1 in figure 2. Length L1 can be divided in various segments s1, s2, s3, s4 depending in the overlap of fieldplates 9A, 9B.

Each gate finger 2A is associated with a respective first region of the channel layer that is arranged underneath that gate finger, and a respective second region of the channel layer that is arranged in between that respective first region and a drain finger among the plurality of drain fingers that is associated with said gate finger.

The 2DEG concentration in the first region can be controlled by applying a voltage to the gate. Typically, HEMT 1 is operated using a positive drain-source voltage. When the gate-source voltage is above the so-called threshold voltage Vt, a current will flow from the drain contact to the source contact. The 2DEG concentration has a maximum value that is determined by the epitaxial layer structure and associated doping profiles. This maximum value of the 2DEG concentration is closely related to the saturation current of HEMT 1.

It is well known that by changing the bandgap energy difference and/or the donor layer thickness, both the saturation current and threshold voltage Vt can change. Consequently, these values are optimized for a given application of HEMT 1.

### SUMMARY

Aspects of the present disclosure relate to a HEMT having improved performance for at least some applications of the HEMT. For this HEMT, a concentration of the 2DEG in absence of any voltage applied to the HEMT in the first region and/or second region associated with a gate finger among the plurality of gate fingers has been lowered, by means of ion-implanting the donor layer, relative to the first region and/or second region associated with a different gate finger among the plurality of gate fingers, respectively. Additionally, or alternatively, a concentration of the 2DEG in absence of any voltage applied to the HEMT in a part of the first region and/or in a part of the second region associated with a gate finger among the plurality of gate fingers has been lowered, by means of ion-implanting the donor layer, relative to a different part of the first region and/or a different part of the second region associated with said gate finger, respectively.

In addition to or instead of using ion implantation, a concentration of the 2DEG in absence of any voltage applied to the HEMT in the first region and/or second region associated with a gate finger among the plurality of gate fingers has been lowered, by means of etching the donor layer, relative to the first region and/or second region associated with a different gate finger among the plurality of gate fingers, respectively. Additionally, or alternatively, a concentration of the 2DEG in absence of any voltage applied to the HEMT in a part of the first region and/or in a part of the second region associated with a gate finger among the plurality of gate fingers has been lowered, by means of etching the donor layer, relative to a different part of the first region and/or a different part of the second region associated with said gate finger, respectively.

For a given gate finger, the abovementioned lowering of the 2DEG concentration may be identical in a direction parallel to that gate finger and non-uniform in a direction perpendicular to that gate finger. Alternatively, the abovementioned lowering of the 2DEG concentration may be non-uniform in a direction parallel to that gate finger and uniform in a direction perpendicular to that gate finger. Alternatively, the abovementioned lowering of the 2DEG concentration may be non-uniform both in a direction parallel to the gate finger and in a direction perpendicular to the gate finger.

According to aspects of the present disclosure, the 2DEG concentration in absence of any voltage applied to the HEMT is not uniformly distributed in the first and/or second region associated with a given gate finger, and/or the 2DEG concentration in absence of any voltage applied to the HEMT is not distributed in the first region and/or second region for each gate in a similar manner. Using this non-uniformity allows the performance of the HEMT as a whole to be optimized.

A part of the donor layer corresponding to the first region and/or second region associated with the gate finger among the plurality of gate fingers of which the 2DEG has been lowered relative to the first region and/or second region associated with a different gate finger among the plurality of gate fingers, respectively, may comprise a first concentration of implanted ions, and a part of the donor layer corresponding to the first region and/or second region associated with the different gate finger, respectively, may comprise a second concentration of implanted ions, wherein the first concentration is greater than the second concentration. Additionally, or alternatively, a part of the donor layer corresponding to a part of the first region and/or part of the second region associated with the gate finger among the plurality of gate fingers of which the 2DEG has been lowered relative to a different part of the first region and/or different part of the second region associated with said gate finger, respectively, may comprise a third concentration of implanted ions, and a part of the donor layer corresponding to said different part of the first region and/or different part of the second region may comprise a fourth concentration of implanted ions, wherein the third concentration is greater than the fourth concentration.

For example, the first concentration may lie in a range between 4e12 and 12e12 #/cm² and the second concentration may lie in a range between 0 and 4e12 #/cm². Additionally, or alternatively, the third concentration may lie in a range between 4e12 and 12e12 #/cm² and the fourth concentration may lie in a range between 0 and 4e12 #/cm². The ions used for said ion-implanting the donor layer can be ions out of the group consisting of Argon ions, Nitrogen ions, Boron ions, Silicon ions, and Phosphorus ions. The ions implanted in the donor layer may locally distort the crystal lattice, thereby effectively reducing the bandgap energy difference with the channel layer.

In some embodiments in accordance with the present disclosure, an average 2DEG concentration in the first region may be higher than an average 2DEG concentration in the second region. In some other embodiments in accordance with the present disclosure, an average 2DEG concentration in the first region may be lower than an average 2DEG concentration in the second region.

The HEMT can be a GaN-based HEMT. In this case, the channel layer may comprise an AlₓGa₁-ₓN layer and the donor layer an Al_{y}Ga_{1-y}N layer. For these layers, x < y, and more preferably 0 <= x <= 0.10 and 0.10 <= y <= 0.50. The ions implanted into the donor layer may remove the Al atoms in the donor layer. To this end, Argon ions may be used.

A part of the donor layer corresponding to the first region and/or second region associated with the gate finger among the plurality of gate fingers in which the 2DEG has been lowered relative to the first region and/or second region associated with a different gate finger among the plurality of gate fingers, respectively, may have a first thickness, and a part of the donor layer corresponding to the first region and/or second region associated with the different gate finger, respectively, may have a second thickness, wherein the first thickness is smaller than the second thickness. Additionally, or alternatively, a part of the donor layer corresponding to a part of the first region and/or part of the second region associated with the gate finger among the plurality of gate fingers in which the 2DEG has been lowered relative to a different part of the first region and/or different part of the second region associated with said gate finger, respectively, may have a third thickness, and a part of the donor layer corresponding to said different part of the first region and/or different part of the second region may have a fourth thickness, wherein the third thickness is smaller than the fourth thickness.

A ratio between the first thickness and the second thickness may lie in a range between 0.5 and 0.9. Additionally, or alternatively, a ratio between the third thickness and the fourth thickness may lie in a range between 0.5 and 0.9.

Reducing the thickness of the donor layer, and more in particular the thickness of that part of the donor layer that provides electrons for the 2DEG, has a lowering effect on the 2DEG concentration, similar to performing the ion implantation described above. These techniques may be combined.

The concentration of the 2DEG in absence of any voltage applied to the HEMT in the first region may be different for more than two gate fingers among the plurality of gate fingers. For example, the concentration of the 2DEG in the first region may be different for at least two gate fingers. Here, the concentration of the 2DEG should be compared at similar or identical positions relative to the gate fingers.

The concentration of the 2DEG in absence of any voltage applied to the HEMT in the second region may be different for more than two gate fingers among the plurality of gate fingers. Here, the concentration of the 2DEG should be compared at similar or identical positions relative to the gate fingers.

The concentration of the 2DEG in absence of any voltage applied to the HEMT in a part of the first region associated with a gate finger among the plurality of gate fingers may be different for more than two other parts of said first region associated with that gate finger. In this case, the 2DEG concentration in absence of any voltage applied to the HEMT in the first region for a given gate finger is not homogenous and may differ depending on the position relative to the gate finger. By dividing the first region associated with a gate finger in a number of parts in which the 2DEG concentration is different, it becomes possible to realize locally different threshold voltages. Typically, a gate finger, drain finger, and source region or finger form a small HEMT that is arranged in parallel with the small HEMTs formed by the other gate fingers, drain fingers, and source regions or fingers. By varying the 2DEG concentration locally for a given gate finger, the abovementioned small HEMT associated with that finger can be construed as a parallel connection of even smaller HEMTs that each may have a different threshold voltage. Compared to HEMTs having a well-defined and uniform threshold voltage, these HEMTs are better suited to withstand high current surges in which the current rises sharply over time. As such, these HEMTs offer an improved safe operating area.

The concentration of the 2DEG in absence of any voltage applied to the HEMT in a part of the second region associated with a gate finger among the plurality of gate fingers may be different for more than two other parts of said second region associated with that gate finger. In this case, the 2DEG concentration in absence of any voltage applied to the HEMT in the second region for a given gate finger is not homogenous and may differ depending on the position relative to the gate finger.

Some or all of the abovementioned possibilities of the concentration of the 2DEG may be combined in a single embodiment.

The 2DEG concentration of substantially only the first regions or second regions associated with the gate fingers may have been lowered. For example, only the donor layer above the first or second regions may have been etched and/or subjected to ion implantation.

The HEMT may further comprise one or more fieldplates associated with a gate finger among the plurality of gate fingers, wherein the one or more fieldplates are preferably connected to a source or gate of the HEMT, and wherein the one or more fieldplates extend at least above respective segments of the second region associated with said gate finger. The one or more fieldplates may comprise a plurality of fieldplates, wherein the second region associated with said gate finger among the plurality of gate fingers comprises a plurality of different segments, each segment corresponding to a different number of fieldplates that extend above it. The 2DEG concentration in absence of any voltage applied to the HEMT may differ among the plurality of different segments that have at least one fieldplate extending above them. By lowering the concentration of the 2DEG underneath the fieldplates the capacitance between these fieldplates and the 2DEG can be lowered. Such lowering is generally not needed in the first region where the 2DEG is shielded by the gate contact layer itself. If the capacitance between the fieldplates and the 2DEG can be controlled, the switching characteristics of the HEMT may improve. Furthermore, the 2DEG concentration in absence of any voltage applied to the HEMT may not have been substantially lowered in a remainder of the second region associated with said gate finger among the plurality of gate fingers.

The 2DEG concentration in absence of any voltage applied to the HEMT in the second regions associated with gate fingers that are arranged in a central portion of the HEMT may be lower than that in the second regions associated with gate fingers that are arranged in an outer portion of the HEMT. In this manner, the saturated current per finger can be lower in the central portion of the HEMT compared to the outer portions of the HEMT. In known HEMTs, where the saturation current per finger at a given temperature is substantially uniform over the HEMT, temperature levels during operation tend to be higher in the central portion of the HEMT. By reducing the 2DEG concentration in the center portion, this non-uniform temperature during operation can be reduced thereby improving the reliability of the HEMT.

According to a further aspect of the present disclosure, the electronic device is a device out of the group consisting of GaN HEMTs configured as a stand-alone device or in cascode with a low-voltage switch, such as a Si MOSFET, and operating in either enhancement-mode or depletion-mode.

According to a further aspect of the present disclosure, a method for manufacturing the multi-finger high-electron mobility transistor, HEMT, as described above is provided. This method comprises providing a semiconductor body comprising a channel layer configured to hold a two-dimensional electron gas, 2DEG, and a donor layer configured to supply electrons for the purpose of forming the 2DEG. The method further comprises forming a plurality of drain fingers, and forming a plurality of gate fingers. Source fingers may be formed substantially simultaneously with forming the plurality of drain fingers.

Each gate finger is associated with a respective first region of the channel layer that is arranged underneath that gate finger, and a respective second region of the channel layer that is arranged in between that first region and a drain finger among the plurality of drain fingers that is associated with said gate finger.

The method further comprises lowering a concentration of the 2DEG in absence of any voltage applied to the HEMT in the first region and/or second region associated with a gate finger among the plurality of gate fingers by means of ion-implanting the donor layer and/or by etching the donor layer, relative to the first region and/or second region associated with a different gate finger among the plurality of gate fingers, respectively.

The method additionally or alternatively comprises lowering a concentration of the 2DEG in absence of any voltage applied to the HEMT in a part of the first region and/or in a part of the second region associated with a gate finger among the plurality of gate fingers by means of ion-implanting the donor layer and/or by etching the donor layer, relative to a different part of the first region and/or a different part associated with the second region of said gate finger, respectively.

The abovementioned ion-implanting is preferably performed prior to forming the plurality of drain fingers. The abovementioned etching of the donor layer is preferably performed prior to forming the plurality of gate fingers.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a schematic top view of a known HEMT
Figure 2 illustrates a cross-sectional view corresponding to the HEMT of figure 1;
Figure 3 illustrates a first embodiment of a HEMT in accordance with an aspect of the present disclosure;
Figure 4 illustrates a second embodiment of a HEMT in accordance with an aspect of the present disclosure;
Figures 5A-5C illustrate various third embodiments of a HEMT in accordance with an aspect of the present disclosure;
Figures 6A-6B illustrate various fourth embodiments of a HEMT in accordance with an aspect of the present disclosure;
Figure 7 illustrates a method of manufacturing a HEMT in accordance with an aspect of the present disclosure; and
Figure 8 illustrates a diode in which the 2DEG concentration is modified similar to the HEMTs of figures 3-7.

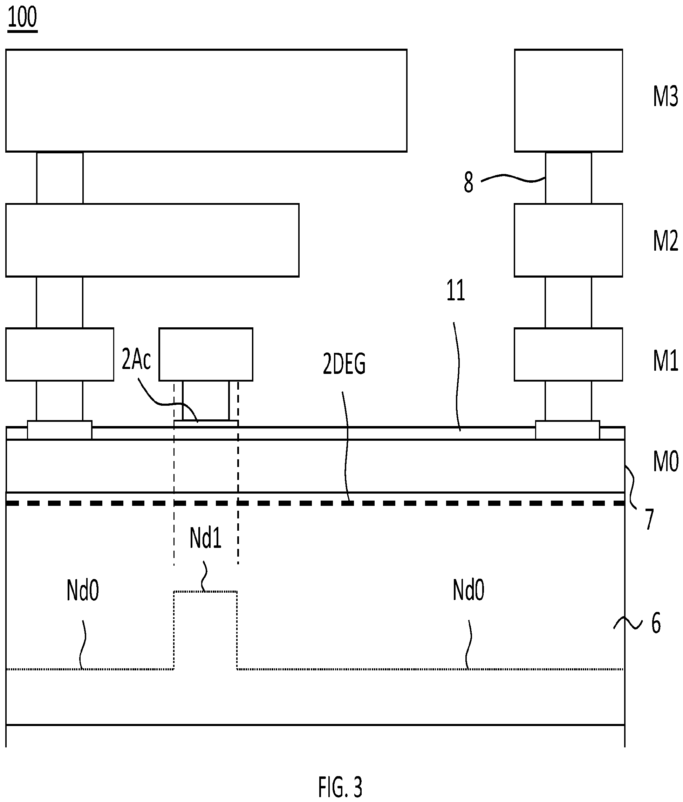

Figure 3 illustrates a first embodiment of a HEMT 100 in accordance with an aspect of the present disclosure. Here, donor layer 7 is subjected to an ion-implantation process as a result of which ions have been implanted into donor layer 7. In this case, Ar+ ions have been implanted. The dose used for this implantation is indicated using the dashed line. Nd0 may represent a background level and may correspond to 0 #/cm², thereby corresponding to no ion implantation at all. As shown, in the first region directly underneath gate contact layer 2Ac, a higher implantation dose has been used. As a result of this implantation, the 2DEG concentration has been lowered and the threshold voltage is shifted to lower values.

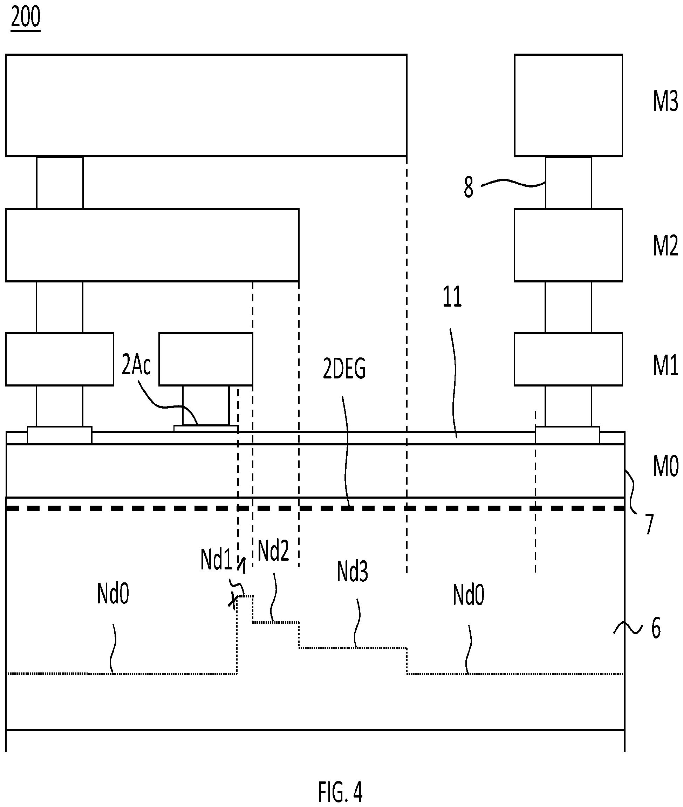

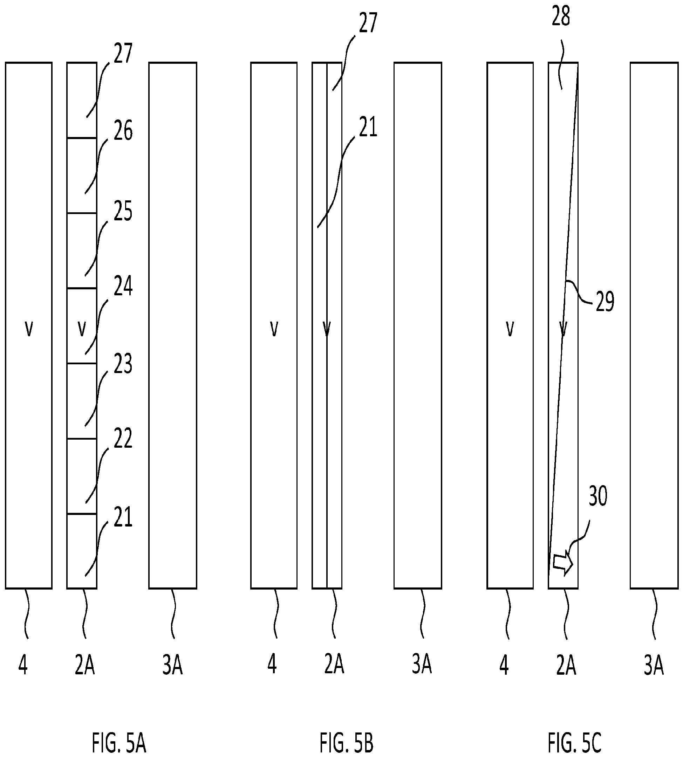

Figures 4 and 5 illustrate different embodiments of a HEMT in accordance with an aspect of the present disclosure. In HEMT 200 shown in figure 4, the first region has essentially not been subjected to ion implantation, or with a background level Nd0, while the second region has been subjected to different ion implantations. More in particular, the first segment of the second region, arranged closest to the first region, and above which fieldplates 9A, 9B and metal layer M1 of gate finger 2A extend, is subjected to the highest implantation dose Nd1. The adjacent segment, above which only fieldplates 9A, 9B extend, is subjected to a lower implantation dose Nd2, and the segment adjacent to that to an ever lower implantation dose Nd3.

The present disclosure is not limited to a configuration in which Nd0<Nd3<Nd2<Nd1. Furthermore, the different doses may be applied to the entire second region for each gate finger or it may be applied to only a part of the second region, for example to stripes in the second region. In this manner, there will exist a variation in the 2DEG concentration in a direction parallel to the gate finger. In addition, the entire first region or parts thereof may also have been subjected to an ion implantation process.

The output capacitance, Coss, being equal to the sum of the drain-source capacitance and the gate-drain capacitance, depends on the applied drain-source voltage. Each step in Coss represents a change in the dV/dt gradient during switching.

A well-designed HEMT will have several steps in Coss, which correspond to the individual contributions made by the retracting 2DEG. The biggest change in Coss always occurs around the threshold voltage of the HEMT and the Coss steps diminish in magnitude as the drain-source voltage is increased due the growing fieldplate-to-2DEG separation.

The sudden changes in Coss lead to unwanted oscillations and overshoots during switching. According to an aspect of the present disclosure, this problem can be mitigated by partially or fully deactivating the 2DEG in the second region to actively manage the contributions to Coss and hence smooth out the overall Coss response.

In the HEMTs shown in figures 5A-5C, of which schematic top views are illustrated, the first region under gate finger contact 2Ac is divided into segments 21-27. Each segment is subjected to a different ion-implantation dose, not excluding embodiments in which one segment is not subjected to ion implantation while others are.

Figure 5A illustrates an embodiment in which the first region is divided in 7 segments 21-27. Among these 7 segments, at least one segment is subject to ion implantation. Moreover, at least two segments among the 7 segments differ with respect to the ion-implantation dose that was used for that segment.

Figure 5B illustrates an embodiment in which the first region is divided in 2 segments 21, 27. Among these segments, at least one segment is subject to ion implantation. Moreover, segments 21, 27 differ with respect to the ion-implantation dose that was used for that segment, not excluding embodiments in which one segment is not subjected to ion implantation while the other is. In this '2-step' example, a lower 2DEG concentration is realized at the edge of the first region to reduce charge trapping and minimize dynamic on-resistance effects.

Figure 5C illustrates an embodiment in which the first region is subjected to a graded ion-implantation. More in particular, line 29 indicates a line in the first region in which the same ion implantation dose has been used. Arrow 30 indicates that a direction in which the ion-implantation dose increases or decreases. More in particular, other lines parallel to line 29 can be drawn that correspond to different ion-implantation doses. In this 'graded' example, the 2DEG concentration is lowered at an angle to create regions with a gradual transition from fully on to fully off.

In the embodiments shown in figures 5A-5C, the second region has not been subjected to ion implantation. As such, the effect of the ion implantation is that the threshold voltage is changed locally. This means that part of a gate finger can be associated with a different threshold voltage than another part of the gate finger. In this manner, the transconductance of the overall HEMT can be controlled.

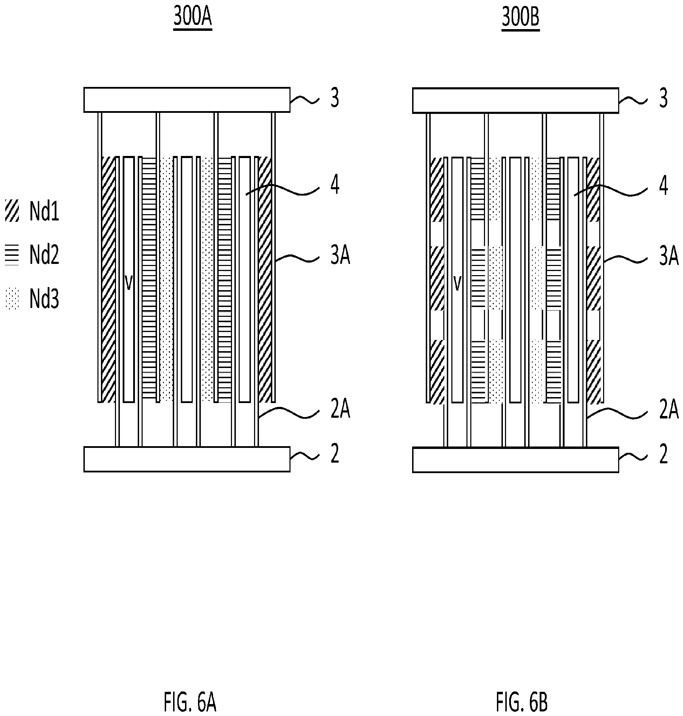

In HEMT 300A shown in figure 6A, the second regions associated with different gate fingers 2A have been subjected to different ion implantation doses. For example, the second regions corresponding to the gate fingers in an outer section of HEMT 300A have been subjected to an implantation dose Nd1, the second regions corresponding to the gate fingers in a center section of HEMT 300A to an implantation dose Nd3, and the remaining gate fingers to an implantation dose Nd2. Here, Nd3>Nd2>Nd1.

As a result of this implantation, the local saturated current will be lower for the gate fingers in the center section than for the gate fingers in the outer sections. Furthermore, current flow into the center gate fingers is suppressed while it is promoted for gate fingers in the outer sections.

For HEMTs having a constant distribution of the saturation current, a considerable increase in temperature in the center section may be observed during operation compared to the temperature in the outer sections. This imbalance and associated risks for reduced reliability are mitigated using the abovementioned ion-implantation approach.

It should be noted that the ion implantation need not be applied to the entire second regions of the gate fingers. For example, the ion implantation may be applied in a stripe pattern as shown for HEMT 300B in figure 6B.

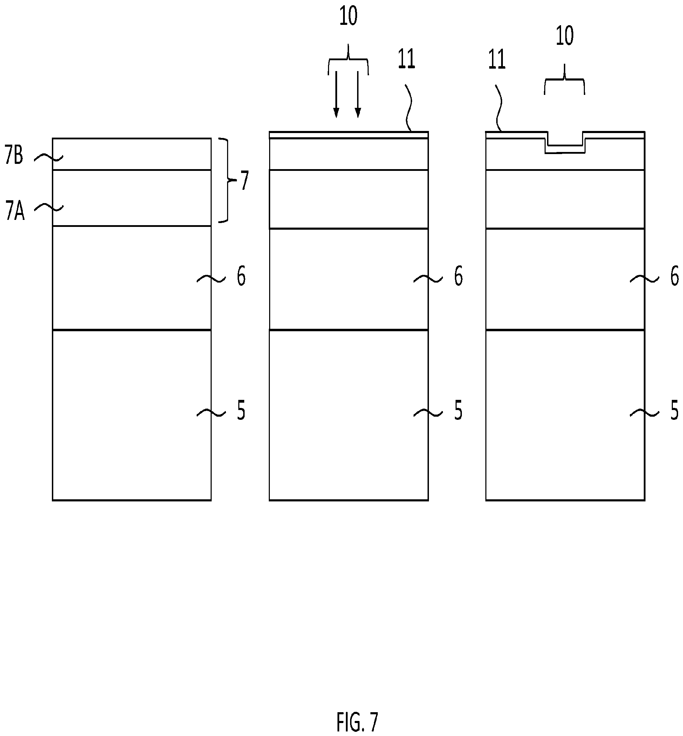

Figure 7, left, illustrates a semiconductor body to be used for a GaN-based insulated-gate HEMT in accordance with an aspect of the present disclosure. It comprises a silicon substrate 5, a GaN buffer layer 6, and a donor layer 7. Here, donor layer 7 comprises a separate GaN cap layer 7B in addition to an AlGaN layer 7A that provides the electrons for forming the 2DEG. The sheet resistance, Rsh, associated with the 2DEG is roughly between 200 and 1000 Ohm/square.

Figure 7, center, illustrates how ion implantation can be performed in a window 10. The step of performing ion implantation is preferably performed after providing the insulation layer that is required underneath the gate contact layer and before providing the drain and source contact layers.

An experimentally verified method of selectively controlling the 2DEG density is by an Ar+ implant directly into the 2DEG region, thus reducing the 2DEG electron concentration, which in turn leads to an increase in 2DEG sheet resistance, Rsh, and a reduction in the local threshold voltage.

As a result of implanting the Ar+ ions, some of the Al atoms in the AlGaN layer are removed, leading to AlGaN barrier relaxation and consequently reducing the strain at the GaN/AlGaN interface, giving lower 2DEG concentration in the implanted region.

The degree of AlGaN barrier relaxation, and hence the reduction in 2DEG concentration, depends on the implant dose and can be changed by at least 2 orders of magnitude with moderate implant doses (10¹² cm⁻²) and at moderate implant energies of around 200 keV for typical GaN HEMTs.

In this implementation, the Ar+ implant is additional to the so-called isolation implant, whose function is to destroy the 2DEG concentration for the purpose of component isolation. Typically, the Ar+ dose would be in the region of 5-10 x10¹² cm⁻² at 180 kV, which is well within the normal capability of commercial implanters used in semiconductor fabs. By applying the ion implantation in window 10, the sheet resistance inside window 10 increases up to 6-16 kOhm/square.

Figure 7, right, illustrates that a reduction of the 2DEG concentration in the first region corresponding to window 10 can also be obtained by reducing the thickness of donor layer 7. As such, instead of using ion implantation in the embodiments discussed in connection with figures 3-6, a reduction of the donor layer thickness could additionally or alternatively have been used.

For GaN-based HEMTs, removing part of the AlGaN barrier by Cl₂-based dry-etching will lead to a less strained AlGaN layer, which will reduce electron concentration in the 2DEG quantum well. For these HEMTs, the insulation layer that is required underneath the gate contact layer is typically applied after performing the abovementioned etching for reducing a thickness of the donor layer.

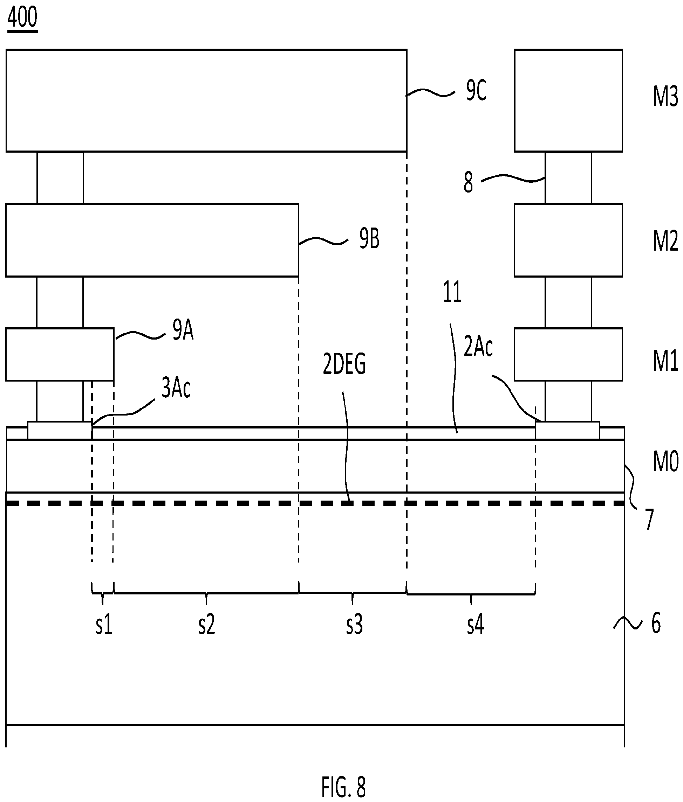

Figure 8 illustrates a diode 400 in which the 2DEG concentration is modified similar to the HEMTs of figures 3-7. Furthermore, the semiconductor body of diode 400 is substantially identical to that of the HEMTs of figures 3-7.

Diode 400 comprises an anode contact layer 2Ac, which forms a Schottky contact with underlying donor layer 7. Cathode contact layer 3Ac forms an Ohmic contact with underlying donor 7. Furthermore, fieldplates 9A, 9B, 9C are connected to cathode contact layer 3Ac. As show, the region of the channel layer in between anode contact layer 2Ac and cathode contact layer 3Ac can be divided in several sections s1-s4. The 2DEG concentration in each of these sections may be modified, either fully or partially, using the abovementioned ion-implantation process and/or the donor layer etching process. More in particular, sections s1-s4 may be modified similar to the different sections in figure 4.

In the above, the present invention has been described using detailed embodiments thereof. However, the present invention is not limited to these embodiments. Instead, various modifications are possible without departing from the scope of the present invention which is defined by the appended claims and their equivalents.

For example, the embodiments shown in the figures are mostly based on GaN. However, the present disclosure is not limited to this technology. Aspects of the present disclosure may equally be used in other material systems such as GaAs, Ga₂O₃, or other III-V semiconductor material systems. For HEMTs, both enhancement and depletion devices may benefit from the aspects of the present disclosure.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A multi-finger high-electron mobility transistor (100; 200; 300A, 300B), HEMT, comprising:
a semiconductor body comprising a channel layer (6A) configured to hold a two-dimensional electron gas, 2DEG, and a donor layer (7) configured to supply electrons for the purpose of forming the 2DEG;
a plurality of gate fingers (2A);
a plurality of drain fingers (3A);
wherein each gate finger is associated with a respective first region of the channel layer that is arranged underneath that gate finger, and a respective second region of the channel layer that is arranged in between that respective first region and a drain finger among the plurality of drain fingers that is associated with said gate finger;
wherein a concentration of the 2DEG in absence of any voltage applied to the HEMT in the first region and/or second region associated with a gate finger among the plurality of gate fingers has been lowered, by means of ion-implanting the donor layer and/or by etching the donor layer, relative to the first region and/or second region associated with a different gate finger among the plurality of gate fingers, respectively; and/or
wherein a concentration of the 2DEG in absence of any voltage applied to the HEMT in a part of the first region and/or in a part of the second region associated with a gate finger among the plurality of gate fingers has been lowered, by means of ion-implanting and/or etching the donor layer, relative to a different part of the first region and/or a different part of the second region associated with said gate finger, respectively.

2. The HEMT according to claim 1, wherein a part of the donor layer corresponding to the first region and/or second region associated with the gate finger among the plurality of gate fingers of which the 2DEG has been lowered relative to the first region and/or second region associated with a different gate finger among the plurality of gate fingers, respectively, comprises a first concentration of implanted ions, and wherein a part of the donor layer corresponding to the first region and/or second region associated with the different gate finger, respectively, comprises a second concentration of implanted ions, wherein the first concentration is greater than the second concentration; and/or
wherein a part of the donor layer corresponding to a part of the first region and/or part of the second region associated with the gate finger among the plurality of gate fingers of which the 2DEG has been lowered relative to a different part of the first region and/or different part of the second region associated with said gate finger, respectively, comprises a third concentration of implanted ions, and wherein a part of the donor layer corresponding to said different part of the first region and/or different part of the second region comprises a fourth concentration of implanted ions, wherein the third concentration is greater than the fourth concentration.

3. The HEMT according to claim 2, wherein the first concentration lies in a range between 4e12 and 12e12 #/cm² and wherein the second concentration lies in a range between 0 and 4e12 #/cm²; and/or
wherein the third concentration lies in a range between 4e12 and 12e12 #/cm² and wherein the fourth concentration lies in a range between 0 and 4e12 #/cm².

4. The HEMT according to claim 2 or 3, wherein ions used for said ion-implanting the donor layer are ions out of the group consisting of Argon ions, Nitrogen ions, Boron ions, Silicon ions, and Phosphorus ions.

5. The HEMT according to any of the previous claims, wherein a part of the donor layer corresponding to the first region and/or second region associated with the gate finger among the plurality of gate fingers of which the 2DEG has been lowered relative to the first region and/or second region associated with a different gate finger among the plurality of gate fingers, respectively, has a first thickness, and wherein a part of the donor layer corresponding to the first region and/or second region associated with the different gate finger, respectively, has a second thickness, wherein the first thickness is smaller than the second thickness; and/or
wherein a part of the donor layer corresponding to a part of the first region and/or part of the second region associated with the gate finger among the plurality of gate fingers of which the 2DEG has been lowered relative to a different part of the first region and/or different part of the second region associated with said gate finger, respectively, has a third thickness, and wherein a part of the donor layer associated with said different part of the first region and/or different part of the second region has a fourth thickness, wherein the third thickness is smaller than the fourth thickness.

6. The HEMT according to claim 5, wherein a ratio between the first thickness and the second thickness lies in a range between 0.5 and 0.9, and/or wherein a ratio between the third thickness and the fourth thickness lies in a range between 0.5 and 0.9.

7. The HEMT according to any of the previous claims, wherein the concentration of the 2DEG in absence of any voltage applied to the HEMT in the first region is different for more than two gate fingers among the plurality of gate fingers; and/or
wherein the concentration of the 2DEG in absence of any voltage applied to the HEMT in the second region is different for more than two gate fingers among the plurality of gate fingers; and/or
wherein the concentration of the 2DEG in absence of any voltage applied to the HEMT in a part of the first region associated with a gate finger among the plurality of gate fingers is different for more than two other parts of said first region associated with that gate finger; and/or
wherein the concentration of the 2DEG in absence of any voltage applied to the HEMT in a part of the second region associated with a gate finger among the plurality of gate fingers is different for more than two other parts of said second region associated with that gate finger.

8. The HEMT according to any of the previous claims, wherein the 2DEG concentration of substantially only the first regions or second regions associated with the gate fingers in absence of any voltage applied to the HEMT has been lowered.

9. The HEMT according to any of the previous claims, further comprising one or more fieldplates (9A, 9B) associated with a gate finger among the plurality of gate fingers, wherein the one or more fieldplates are preferably connected to a source or gate of the HEMT, and wherein the one or more fieldplates extend at least above respective segments of the second region associated with said gate finger.

10. The HEMT according to claim 9, wherein the one or more fieldplates comprise a plurality of fieldplates, wherein the second region associated with said gate finger among the plurality of gate fingers comprises a plurality of different segments, each segment corresponding to a different number of fieldplates that extend above it, wherein the 2DEG concentration in absence of any voltage applied to the HEMT preferably differs among the plurality of different segments that have at least one fieldplate extending above them.

11. The HEMT according to claim 9 or 10, wherein the 2DEG concentration in absence of any voltage applied to the HEMT has not been substantially lowered in a remainder of the second region associated with said gate finger among the plurality of gate fingers.

12. The HEMT according to any of the previous claims, wherein the 2DEG concentration in absence of any voltage applied to the HEMT in the second regions associated with gate fingers that are arranged in a central portion of the HEMT is lower than that in the second regions associated with gate fingers that are arranged in an outer portion of the HEMT.

13. The HEMT according to any of the previous claims, wherein the HEMT is a GaN-based HEMT, wherein the channel layer preferably comprises an AlₓGa₁₋ₓN layer and the donor layer an Al_{y}Ga_{1-y}N layer, wherein x < y, wherein more preferably 0 <= x <= 0.10 and 0.10 <= y <= 0.50.

14. An electronic device comprising the HEMT as defined in any of the previous claims, wherein the electronic device is a device out of the group consisting of GaN HEMTs configured as a stand-alone device or in cascode with a low-voltage switch, such as a Si MOSFET, and operating in either enhancement-mode or depletion-mode.

15. A method for manufacturing the multi-finger high-electron mobility transistor, HEMT, as defined in any of the previous claims, comprising:
providing a semiconductor body comprising a channel layer configured to hold a two-dimensional electron gas, 2DEG, and a donor layer configured to supply electrons for the purpose of forming the 2DEG;
forming a plurality of drain fingers;
forming a plurality of gate fingers;
wherein each gate finger is associated with a respective first region of the channel layer that is arranged underneath that gate finger, and a respective second region of the channel layer that is arranged in between that first region and a drain finger among the plurality of drain fingers that is associated with said gate finger;
the method further comprising:
lowering a concentration of the 2DEG in absence of any voltage applied to the HEMT in the first region and/or second region associated with a gate finger among the plurality of gate fingers by means of ion-implanting the donor layer and/or by etching the donor layer, relative to the first region and/or second region associated with a different gate finger among the plurality of gate fingers, respectively; and/or
lowering a concentration of the 2DEG in absence of any voltage applied to the HEMT in a part of the first region and/or in a part of the second region associated with a gate finger among the plurality of gate fingers by means of ion-implanting the donor layer and/or by etching the donor layer, relative to a different part of the first region and/or a different part of the second region associated with said gate finger, respectively;
wherein the ion-implanting is preferably performed prior to forming the plurality of drain fingers; and/or
wherein the etching of the donor layer is preferably performed prior to forming the plurality of gate fingers.
